# EUROPEAN PATENT APPLICATION

(11) **EP 0 572 121 A2**
(43) Date of publication of application: **01.12.1993**
(21) Application number: 93303409.2
(22) Date of filing: 30.04.1993
(51) Int. Cl.: H05K 3/00, H05K 3/46, H05K 3/10

(54) **Method of making circuit board**

(30) Priority: 29.05.1992 JP 138815/92
(71) Applicant: SUMITOMO ELECTRIC INDUSTRIES, LIMITED, Osaka 541 (JP)
(72) Inventor: Ihara, Tomohiko, c/o Itami Works, Itami-shi, Hyogo (JP); Yoshino,Hiroshi Sumitomo Electric Ind.Ltd., Itami-shi Hyogo (JP); Hattori, Hisao, c/o Itami Works, Itami-shi, Hyogo (JP); Yamanaka, Shosaku, c/o Itami Works, Itami-shi, Hyogo (JP)
(74) Representative: Bankes, Stephen Charles Digby

(57) **Abstract**

A method of making circuit boards in which the thickness of an insulating layer (2) is held constant to ensure the fine configuration and dimensions of wiring lines and further to prevent variations in wiring intervals and wiring grounds due to unevenness of the insulating layer, thereby preventing electric characteristics from varying. The method comprising the steps of stacking an insulating layer (2) on an insulating substrate (1), and engraving the insulating layer into a wiring configuration, for example by exposure and development. A metal layer (3) is formed thereon, and photoresist is removed. This sequence of steps can be repeated as necessary obtaining a layer-structure wiring board.

## Description

The present invention relates to a method of fabricating circuit boards to be used for semiconductor devices, microwave hybrid integrated circuits (ICs), and the like.
As semiconductor devices, microwave hybrid ICs, and the like for use in computers and the like have developed and been miniaturized and improved for high speed circuit boards used for wiring these electronic components and devices, as well as methods of fabricating them, have also been developed in various ways.

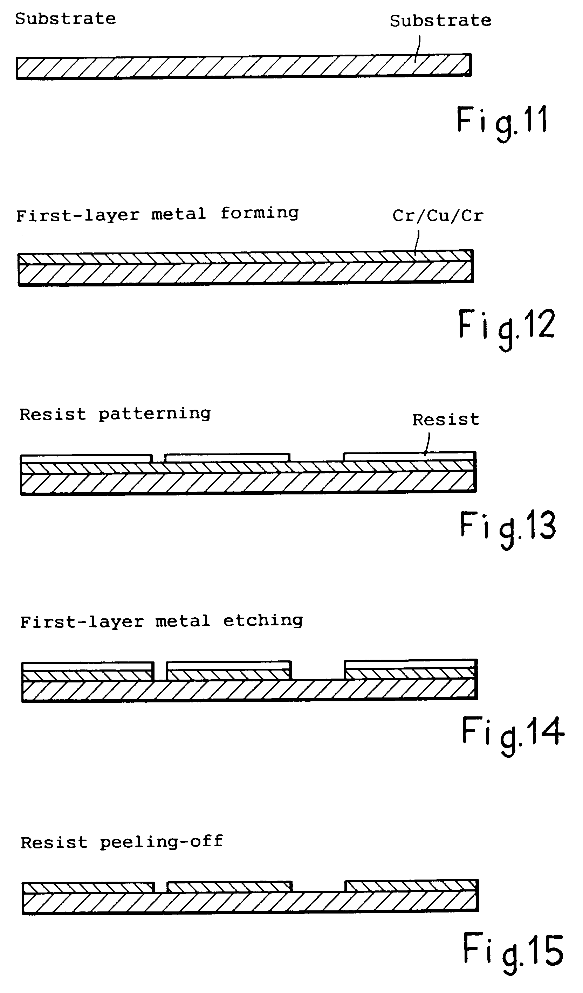

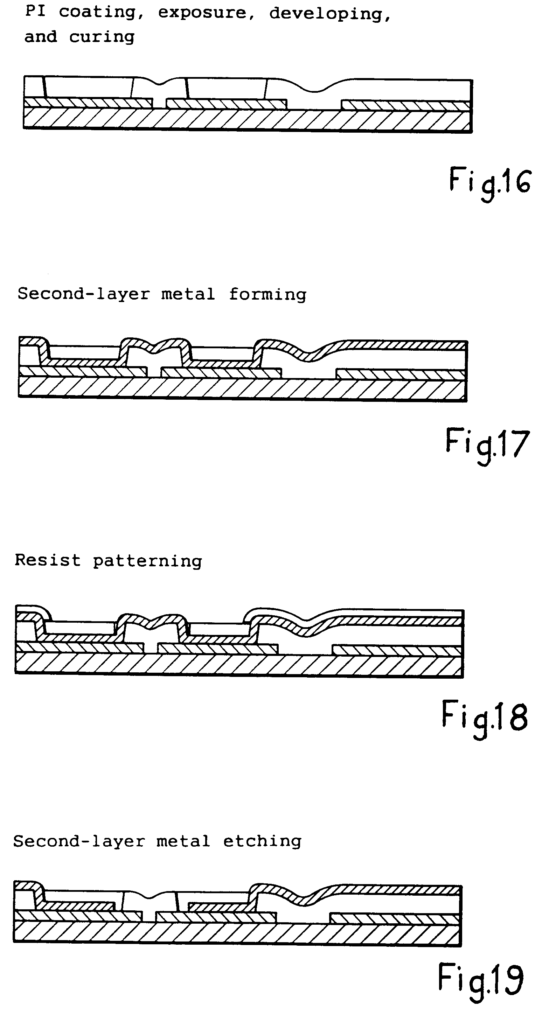

In particular a common method of fabricating circuit boards has been implemented by a process as shown in Figs 11 to 19 of the accompanying drawings. First, a thin-film metal layer containing, e.g. copper is formed all over a glass- or ceramic-laminate wiring substrate. Then, resist of a specified pattern is applied on the metal layer, and the metal layer is etched with a solution. Thereafter, the resist is peeled off, and an insulating layer of, e.g. polyimide (PI), is applied on the exposed metal layer. The polyimide insulating layer is exposed to light and developed by photolithography, thereby forming through holes, and then cured by firing or the like.

Next, all over the surface of the insulating layer, a thin-film second metal layer is formed as a wiring layer by vapour deposition or the like. A photoresist is formed thereon at a thickness greater than the required wiring thickness, and then wiring is formed by plating. After the resist is patterned, the thin metal layer remaining over the surface is removed. Further thereon, an insulating layer is formed.

An example of such prior-art method of fabricating circuit boards is known from "High-Density Multilayer Interconnection with the Photo-Sensitive Polyimide Dielectric and Electroplating Conductor, "K. Moriya, T Ohsaki and K Katsura, p 19, a research report read at the research conference "34th Electronic Components Conference".

Another example is the one proposed in "Development in Copper Polyimide Substrates", Kurumi Yamada and seven others, a technical research report CPM-63 by the Institute of Electronics and Communication Engineers of Japan, pp. 29 - 34, dated December 29, 1986.

However, as pointed out in the first research report indicated above a prior art, when the line width of the wiring layer becomes finer, it also becomes difficult to ensure the wiring configuration, especially the verticality of its vertical side wall portion. As a result, the wiring configuration becomes generally trapezoidal, such that the dimensional precision matters if it falls in a wiring thickness of a quarter or more relative to width. Accordingly, the resulting characteristic impedance becomes unstable, making it difficult to use such a common method of fabricating circuit boards.

Further, as is the case with both of the above two methods, since in such methods of fabricating circuit boards the wiring layer is formed before the insulating layer is formed, the flatness of polyimide of the insulating layer tends to be poor, causing wiring intervals and wiring ground intervals to be varied, with the result that the characteristic impedance of the wiring becomes unstable. Moreover, when the wiring thickness becomes greater, the surface irregularity becomes greater, lowering the resolution of the patterns formed in the resist by photolithography and therefore lowering the wiring precision, so that the resulting electrical characteristics vary to a considerable extent.

Accordingly, the present invention has as its principal object to provide a method of fabricating circuit boards, in which the thickness of the insulating layer can be held constant and the configuration and dimensions of the wiring layer ensure more easily than in the prior art, to enhance the evenness of the insulating layer and thus prevent the wiring intervals and wiring ground intervals from varying, thereby reducing variations in electrical characteristics.

The present invention provides a method of fabricating circuit boards having a single wiring layer or alternate wiring layers and insulating layers, the wiring layers being connected one to another with via holes or through holes, the method comprising the steps of: stacking an insulating layer on a substrate, engraving the layer structure according to the wiring configuration, forming a metal layer all over or partially over the layer structure, and thereafter forming wiring patterns by etching.

For this method, the insulating layer preferably comprises a polyimide resin, epoxy resin, polytetrafluorethylene (PTFE) resin. Any one of the resins for the insulating layer may be a photosensitive one and the engraving treatment may comprise a combination of exposure and development.

Further, liquid phase etching may be used for the engraving treatment.

According to the above-described method of fabricating circuit boards, the insulating layer is formed at a required wiring thickness and portions thereof where the wiring is provided are subjected to engraving treatment, and a metal layer of a thickness equal to the wiring thickness is formed thereon. Then a resist pattern is formed according to the wiring pattern, followed by etching. With an approximately flat surface obtained by the foregoing steps (i.e. a wiring-buried state), the insulating layer is formed to a thickness required as the distance between wiring layers. Thus, the thickness between the wiring layers can also be held constant, allowing the wiring precision to be maintained at a high level.

A preferred embodiment of the present invention will now be described with reference to the accompanying drawings, in which:
Figs 1 to 10 are explanatory cross-sectional views of a method of fabricating circuit boards according to an embodiment of the present invention; and
Figs 11 to 19 are explanatory cross-sectional views of a prior-art method of fabricating circuit boards.

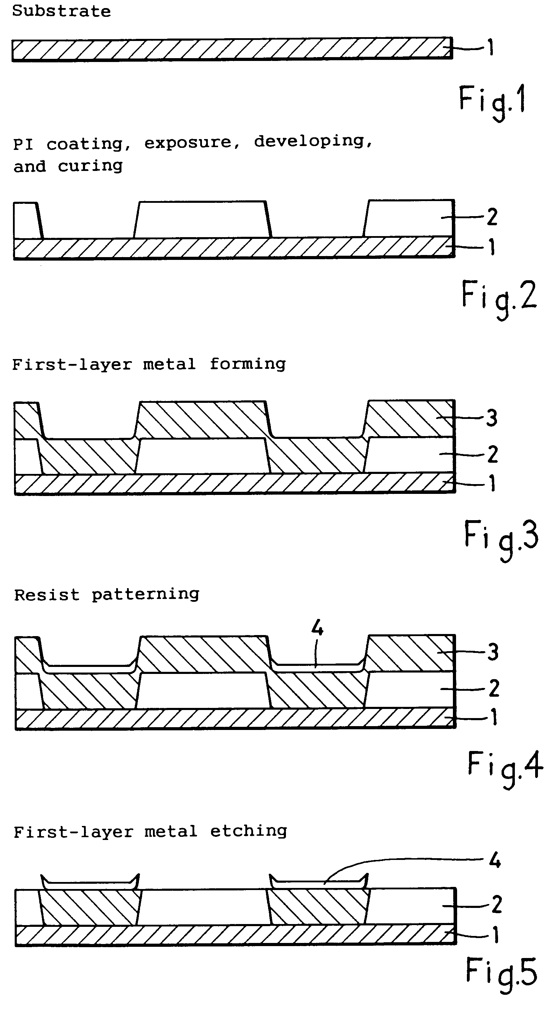

Each of the figures 1 to 10 shows a circuit board in section, at a given stage of its manufacture.

In Fig 1 a glass substrate or alumina ceramic substrate is prepared as a dielectric substrate 1. In Fig 2, an insulating layer 2 is applied onto the substrate 1 by spin coating, and cured in a nitrogen atmosphere. The insulating layer 2 can be provided by, for example, a photosensitive polyimide resin. On the insulating layer, resist is applied, although not shown, and exposed to light and developed to form a resist pattern. With the resulting resist pattern used as a mask, the process of dry etching is carried out with oxygen plasma by using a dry-etching system, whereby portions of the layer corresponding to the wiring pattern are engraved as shown in Fig 2.

Thereafter, as shown in Fig 3, a metal layer 3 of a thickness equal to the wiring thickness is formed by being deposited all over the aforementioned insulating layer 2 and the substrate 1 by spluttering. Subsequently, as shown in Fig 4, the resist 4 is patterned on the metal layer 3 by photolithography. In Fig 5, the portions of the metal layer 3 exposed by etching are removed by further wet etching.

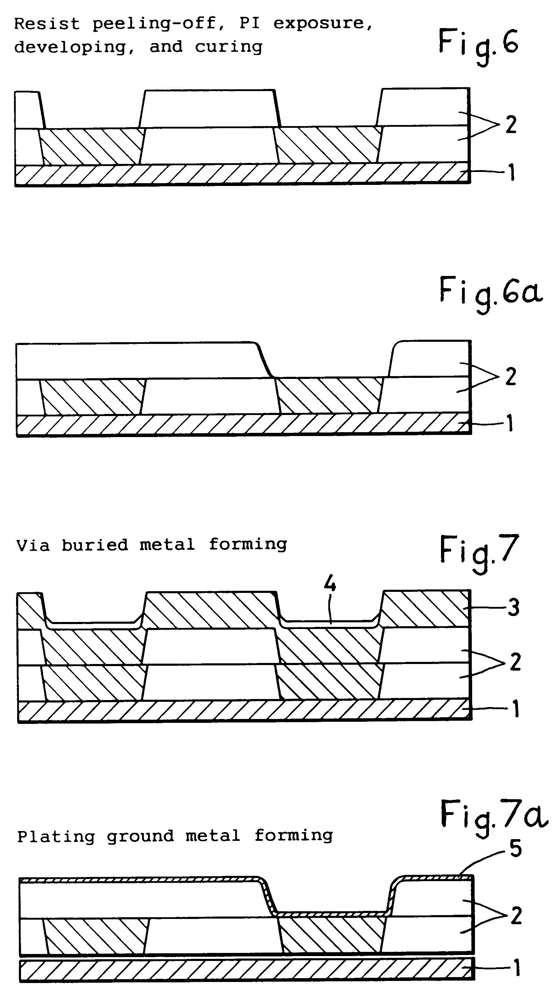

In Fig 6, the remaining resist on the first metal layer 3 formed by the foregoing steps has been removed, and a further insulating layer 2 is stacked thereon by effecting again the application, exposure to light, development, and curing in the same way as in Fig 2, to give two stages of the insulating layer 2.

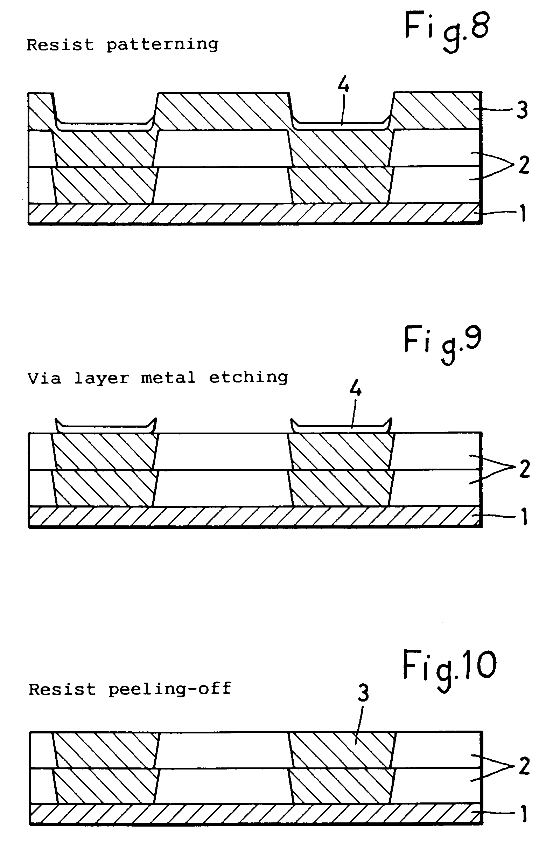

Subsequently, in the same manner as with the first layer, a second metal layer 3 is overlaid as shown in Fig 7 resist is patterned as in Fig 8, the metal layer 3 is etched as in Fig 9, and the resist is peeled off to give a flat printed circuit layer as shown in Fig 10.

It is a matter of course that if a multilayer circuit board of third, fourth or more layers is desired, this can be achieved by repeating again the steps for the first layer.

It to be noted that if a layer of plating base material 5 is to be formed on the wiring of the first layer, as shown in Fig 6a the insulating layer 2 may be formed as a pattern corresponding to the plating base material 5 and then the layer of plating base material 5 formed thereon.

As a specific example, a circuit board according to the above-described embodiment was prepared as follows.

After a 10 µm thick polyimide resin layer 2 was formed on a substrate 1 by spin coating and curing, the portions of the layer which form the wiring was engraved (thickness: 10 µm) by a dry-etching system. Thereafter, a 10 µm metal layer 3 was formed by deposition, and a resist pattern 4 was formed, followed by etching, thus accomplishing the wiring-buried state. In this case, the wiring width was 25 µm with a pitch of 50 µm. A further 10 µm thick polyimide layer 2 was formed. By repeating these steps, dual-strip wiring was formed with the use of meshed ground at a porosity rate of 42% above and below.

The characteristic impedance of the wiring was 50 to 60 Ω, and the wiring resistance was 1.5 Ω/cm. The flatness was ± 1 µm.

When the circuit board was formed by the method according to the prior art of the first research report referred to above for the purpose of comparison, the wiring resulted in a trapezoid, with the wiring resistance around 2 Ω/cm.

Also, the flatness which would matter in both of the two prior-art methods mentioned before was ± 6 to 8 µm.

By applying the above-described embodiment of the invention the following products were fabricated.

### Application Example 1

A circuit was formed on a ceramic laminate by using photosensitive polyimide as the insulating layer, fabricating a package which allows a plurality of semiconductor devices to be mounted thereon. The polyimide resin was 10 µm in thickness and the metal layer was 10 µm. The resulting wiring was 25 µm in width, 50 µm in pitch, being a five-layer circuit and a 600-pin pad array package of 100 mm square in outside dimensions. This product, when applied in actual circuit use, has shown to be able to operate a microprocessor unit (MPU) circuit that is capable of operating at a clock frequency of 200 MHz. In this example, using the photosensitive polyimide allowed the manpower to be reduced to approximately two thirds.

### Application Example 2

A 500mm square printed board was fabricated by using a photosensitive epoxy resin on a glass epoxy substrate. This is fabricated into a central processing unit (CPU) board. The epoxy resin was 20 µm in thickness, and the metal layer was 20 µm. The wiring was 70 µm in thickness and 150 µm in pitch, being four layers in one side and eight layers in both sides. In this example, a CPU board which can operate at a clock frequency of 100 MHz was fabricated.

### Application Example 3

A multilayer microwave hybrid ICMIC board was fabricated on a high-purity alumina ceramic substrate by using a PTFE (Teflon^{(R)} resin as the insulating layer. In this case, adopting a buried wiring helped reduce the wiring resistance to low level, with the result of a multilayer wiring with an S11 of -20 dB or lower, and an S12 of 3 dB or lower at 20 GHz.

As above described in detail, the method of fabricating circuit boards according to the present invention comprises the steps of stacking an insulating layer on a substrate, engraving the layer structure according to a wiring configuration, forming thereon a metal layer, and forming a wiring pattern by etching. Thus, the thickness of the insulating layers between wiring layers can be held constant while the wiring precision is constant without being affected by the other wiring layers. Accordingly, flatness can be kept from any deterioration even if the wiring thickness is increased. As a result, variation in electrical characteristics of the wiring can be reduced, allowing higher-frequency circuits to be fabricated.

Therefore, the resulting wiring resistance is low and the wiring configuration precision is greatly enhanced so that damping and wavelength distortion in wiring can be suppressed while the wiring density can be improved. This allows the circuit, system, module and products to be miniaturized, and their speed increased simultaneously.

## Claims

1. A method of making circuit boards having a single wiring layer or alternating wiring layers and insulating layers, the wiring layers being connected one to another with via holes or through holes, the method comprising the steps of: stacking an insulating layer (2) on a substrate (1); engraving the layer according to the wiring configuration forming a metal layer (3) all over or partially over the engraved layer; and thereafter forming wiring patterns by etching.

2. A method as claimed in claim 1, wherein the insulating layer (2) is made of any one of a polyimide resin, epoxy resin, and polytetrafluorethylene resin.

3. A method as claimed in claim 2, wherein at least one resin of the insulating layer (2) is photosensitive, and the engraving process is in combination of exposure and development.

4. A method as claimed in claim 1 or claim 2, wherein the engraving process involves liquid phase etching.
